**Europäisches Patentamt**

**European Patent Office**

**Office européen des brevets**

(19)

(11) **EP 1 096 368 A1**

(12) **EUROPEAN PATENT APPLICATION**

(43) Date of publication:
02.05.2001 Bulletin 2001/18

(51) Int Cl.[7]: **G06F 7/48**, H03M 1/66

(21) Application number: 99120833.1

(22) Date of filing: 25.10.1999

(84) Designated Contracting States:
**AT BE CH CY DE DK ES FI FR GB GR IE IT LI LU MC NL PT SE**
Designated Extension States:
**AL LT LV MK RO SI**

(71) Applicant: **Telefonaktiebolaget L M Ericsson (Publ)**
**126 25 Stockholm (SE)**

(72) Inventors:
• **Gustafson, Jerker**
**14162 Huddinge (SE)**
• **Ebbesson, Hans**
**12638 Hägersten (SE)**

(74) Representative: **HOFFMANN - EITLE**
**Patent- und Rechtsanwälte**
**Arabellastrasse 4**
**81925 München (DE)**

(54) **Method and circuit for resolution adaption**

(57)    A method and circuit are described, in which a digital processing value $d_i$ of a first resolution is adapted to a second, lower resolution. A term $\delta_i$ of the second resolution is determined in dependence of the accumulated remainders that are generated when an adapted value $\{d_i\}_{r2}$ is calculated from the processing value $d_i$. The term $\delta_i$ is set equal to said adapted value $\{d_i\}_{r2}$ if the accumulated remainders do not exceed a predetermined threshold, and if the threshold is exceeded, then the term is set equal to the sum of the adapted value and the second resolution interval $r_2$.

*FIG.2*

**Description**

Field of the invention

The present application is directed towards a method and device for resolution adaptation in a digital system, especially in a system where digital values of high resolution are adapted for processing by a D/A converter of lower resolution.

Background of the invention

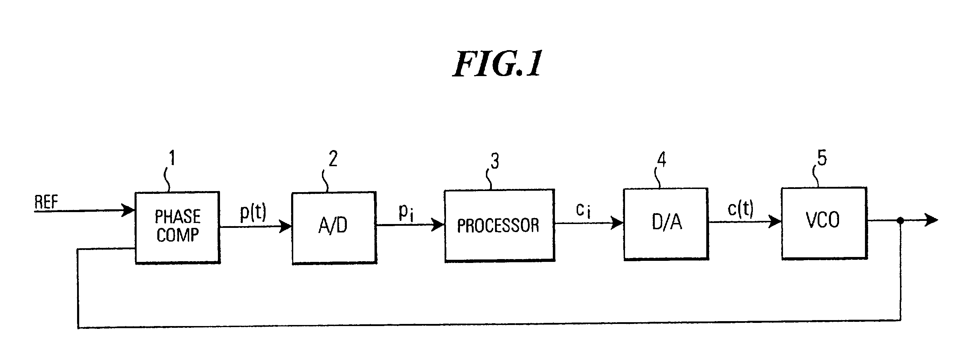

Figure 1 shows a phase locked loop (PLL) circuit, in which a phase comparator 1 compares a reference signal and an output signal of the PLL circuit. The phase comparator 1 outputs an analogue signal p(t) as a result of the comparison. The signal p(t) is input into an A/D converter 2, which outputs digital values $p_i$ representative of the signal p(t). Then a processor 3 processes these values $p_i$ in a desired way, e.g. according to a proportional regulating scheme, a PI-regulating scheme, or a PID-regulating scheme. The result is digital value $c_i$, which are supplied to a D/A-converter for conversion into an analogue control signal for a voltage controlled oscillator (VCO) 5. The output of VCO 5 is fed back to the phase comparator 1 to thereby close the loop.
Such a PLL circuit can e.g. be part of a network synchronization element.
The D/A conversion device constituted by the processor 3 and the actual D/A converter 4 is typically arranged such that the digital resolution of the processor 3 is higher than the digital resolution of D/A converter 4. Therefore, the values $c_i$ output by the processor, which are provided at the resolution of the D/A converter 4, must be reduced in resolution by the processor 3 before being output.
Expressed in more detail, the function of the processor 3 is to determine control values $c_i$ on the basis of the phase comparison values $p_i$. This can generally be expressed by

$$f_i = f( p_i, p_{i-1}, ...),$$

where f(p) represents the function for processing the values $p_i$, which can include previous values. For example, f can be defined as $f_i=K\cdot(f_i-f_{i-1})$.
The values $f_i$ are digital values calculated at a resolution interval $r_1$. This means that the values $f_i$ can be represented as multiples of $r_1$, or in other words $r_1$ is the smallest unit or increment for $f_i$. On the other hand, the resolution interval for $c_i$ is determined by the resolution of the D/A converter, and is represented as $r_2$, where $r_2 > r_1$, i. e. the values of $f_i$ are calculated at higher resolution than the values of $c_i$.
Consequently, the values $f_i$ at resolution interval $r_1$ must be mapped onto values $c_i$ at resolution interval $r_2$. The straight forward approach to deriving the values of $c_i$ from the values of $f_i$ consists in simple truncation:

$$c_i = \lfloor f_i \rfloor_{r_2}$$

which is supposed to mean that the values $f_i$ are simply truncated to the resolution provided by $r_2$.
This approach can lead to problems. For example, if the processor 3 implements PI-regulation and the value of the proportional constant Kp (for example, as expressed in: $f_i = f_{i-1} + K_P \cdot(p_i - p_{i-1}) + K_I \cdot \Delta t \cdot p_i$) is small and the resolution of D/A converter 4 is low (i.e. $r_2$ is large), then this can lead to the occurrence of dead regions at even intervals in the control range of the regulator.
The straight forward solution to this problem is to increase the resolution of the D/A converter 4. However, this increases the costs of the component, and in practice requires considerable effort for redesign. An alternative solution in the above case of a PI-regulator would be to increase the value of $K_p$, but this would have a very negative impact on the jitter transfer characteristics, which is not acceptable in a network synchronizing element. Although the above problem has been explained in connection with a PLL circuit, it may be noted that it will basically occur in any system, in which digital values are processed at a high resolution and need to be output at a lower resolution.

Summary of the invention

The object of the present invention is to solve the above mentioned problem and to provide a method and device for improved resolution adaptation of digital process values of a first resolution to a second resolution, said first resolution being higher than said second resolution.
This method is solved by the subject-matter of the independent claims. Advantageous embodiments are disclosed in the dependent claims.

Due to the method and circuit of the invention, the low resolution provided by an element in a circuit (such as e.g. a PLL circuit) can be "improved" by taking into account the rest or remainder values that appear in the processing of digital values in a processor supplying values for said low resolution element, where the resolution of said processor is higher than in said element. This "improvement" is achieved without any changes in the actual resolution of the element, such that no higher production costs are caused and no redesign effort is necessary.

Brief description of figures

The features and advantages of the present invention will become more readily understandable from the following description of preferred embodiments, where reference is made to the accompanying drawings, in which:

Fig. 1    shows a PLL circuit to which the present invention can be applied, and

Fig. 2    shows a flow chart of a basic embodiment of the present invention.

Detailed description of embodiments

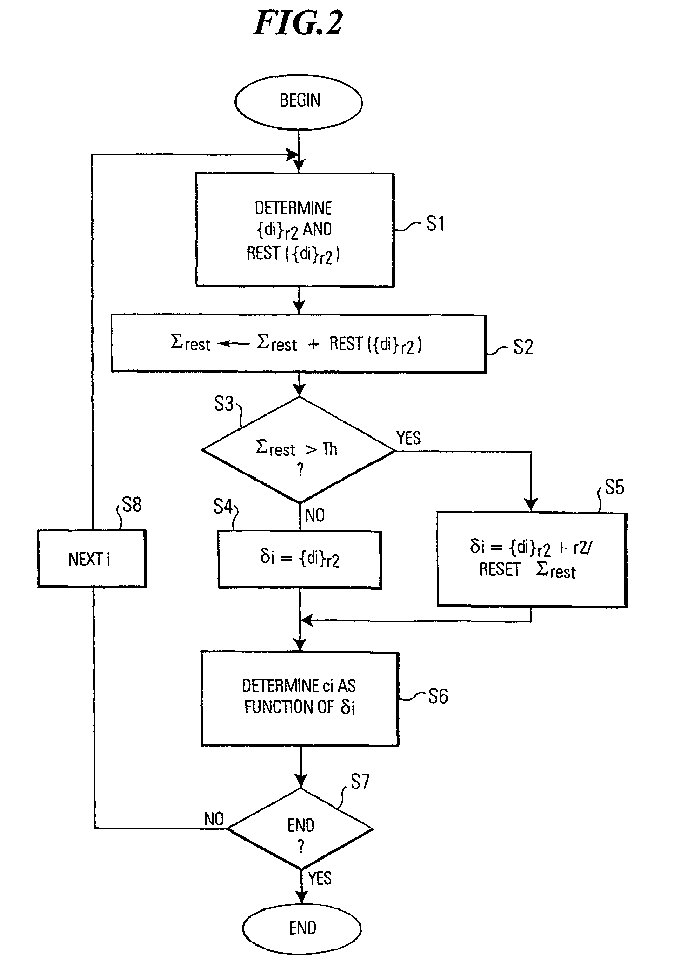

Now a detailed explanation of the present invention shall be given. Fig. 2 shows a flow diagram of an embodiment of the present invention. This method can e.g. be applied to the processor 3 in the PLL circuit shown in Fig. 1, of which the elements were described above, such that a repetition is not necessary. The description of this PLL circuit is herewith incorporated into the description of the present invention. It should however be noted that the present invention is by no means restricted hereto, and can be applied to any circuit or system in which a digital processing value of a given resolution is adapted to a lower resolution.

In a first step S1 a digital processing value $d_i$ of a first resolution is adapted to a value $\{d_i\}$ of a second, lower resolution. The first resolution is represented by a resolution interval $r_1$, such that $d_i$ is a multiple of $r_1$, i.e. $d_i = r_1 \cdot n$, where n is a natural number. The second resolution is represented by a resolution interval $r_2$, such that $\{d_i\}_{r2}$ is a multiple of $r_2$, i.e. $\{d_i\}_{r2} = r_2 \cdot m$, where m is a natural number. The interval are such that $r_2 > r_1$, i.e. the second resolution is lower than the first. As an example, the first resolution could be 32 bits, whereas the second resolution could be 24 bits.

The determination of the adapted value $\{d_i\}_{r2}$ can be done in any desired way, for example by an operation of multiplication and division, or by simple truncating. Generally, this means that a part of $d_i$ is cut off. Preferably, the adaptation is done by simple truncating, such that

$$\{d_i\}_{r2} = \lfloor d_i \rfloor_{r2}$$

The index r2 indicates that the result is at the resolution associated with r2.

Furthermore, step S1 comprises determining a rest or remainder representative of the difference between the processing value $d_i$ and the adapted value $\{d_i\}_{r2}$. This remainder Rest $(\{d_i\}_{r2})$ is preferably the difference between the two values, such that

$$\mathrm{Re}\,st(\{d_i\}_{r2}) = d_i - \{d_i\}_{r2}$$

but the remainder can e.g. also be any desired function of this difference. In the case of $d_i$ simply being truncated, this becomes:

$$\mathrm{Re}\,st(\{d_i\}_{r2}) = d_i - \lfloor d_i \rfloor_{r2}$$

The rest value is provided at the first resolution.

In step S2 the rest value is added to a summation value representative of the sum of previous rest values:

$$\sum_{Rest} \leftarrow \sum_{Rest} + \operatorname{Re}st(\{d_i\}_{r2})$$

In other words, the summation value $\Sigma_{Rest}$ takes the remainders of the adaptation processing into account.

The, in step S3, the summation value $\Sigma_{Rest}$ is compared to a threshold value Th. This threshold value Th can be chosen as desired, but is preferably equal to the second resolution interval $r_2$.

If the result of step S3 is negative, then the procedure moves to step S4, in which a term $\delta_i$ is set equal to the adaptation value $\{d_i\}_{r2}$. On the other hand, if the result is affirmative, the procedure moves to step S5. In step S5 the term $\delta_i$ is set equal to the sum of the adaptation value $\{d_i\}_{r2}$ and the second resolution interval $r_2$. Thereby, each time that the summation value exceeds the threshold, the value of the term $\delta_i$ is raised by one unit of resolution, which means that the average value of the term $\delta_i$ rises, which provides a value between the resolution steps provided by the second resolution. This artificially "increases" the resolution, even though the actual resolution is still determined by $r_2$.

Then, as a second part of step S5, the summation value $\Sigma_{Rest}$ is reset to a desired value, e.g. zero. Preferably, $\Sigma_{Rest}$ is reset such that the reset value is equal to the difference between the old value and the second resolution interval $r_2$. In that way, no accumulated rest information is lost.

In the above example, the value added to the adaptation value $\{d_i\}_{r2}$ is one unit of resolution. In general, the value added to the adaptation value in the case of step S5 can be the product of the second resolution interval $r_2$ and a natural number. The choice of this natural number will generally depend on the value of the threshold, and the mode of resetting $\Sigma_{Rest}$ will depend on the value of the threshold and the value added in step S5. For example, if the threshold Th is equal to $r_2$, then the value added in S5 is preferably also $r_2$, and $\Sigma_{Rest}$ is preferably reset to $\Sigma_{Rest}$-$r_2$. In general, these operations can also be conducted such that for a general threshold Th, the value added in step S5 is $\{\Sigma_{Rest}\}_{r2}$, and the resetting is done by $\Sigma_{Rest} \leftarrow \Sigma_{Rest}$ - $\{\Sigma_{Rest}\}_{r2}$.

Next, in step S6, the output value $c_i$ at the second resolution is determined. This output value $c_i$ is determined by using the term $\delta_i$ provided by either step S4 or S5. In a simplest case, the value $c_i$ can be equal to the term $\delta_i$. In other words, when considering the function f mentioned above, this means that the digital processed value $d_i$ to which the method of Fig. 2 is applied, is the function value $f_i$.

It is however equally well possible that the output value $c_i$ is determined as a function (e.g. a sum) of a plurality of terms, of which the above mentioned term $\delta_i$ is one. If the value $c_i$ is determined on the basis of a number of terms, the method described in connection with Figure 2 can also be applied to all or only some of these terms.

According to a preferred embodiment, the output value $c_i$ is calculated on the basis of PI-regulation, where each value of $c_i$ is the sum of a proportional term and an integral term. In accordance with the preferred embodiment, only the proportional term is processed in accordance with the method of Fig. 2, whereas the integral part is only adapted to the lower resolution in the same way as the adapted value $d_i$ is determined, e.g. by truncating or by another suitable operation. In this way, the adding of the resolution interval $r_2$ does not accumulate in the integral part.

Naturally, $c_i$ could also be determined on the basis of PID-regulation, which means that three terms are added. Then the method of Fig. 2 could be applied to the proportional term alone, or to the proportional term and the differential term.

Returning to Fig. 2, after step S6, the procedure either ends (step S7 affirmative) or loops back for the next value (S7 negative and step S8).

It is well understandable to the skilled person that the detailed procedure described in connection with Fig. 2 is representative of the basic flow, but that an actual implementation could arrange and combine the specific steps differently from what is shown in the Figure, without leading to a different result. In other words, all such varying implementations fall under the same method.

For example, in a specific embodiment where the method of the invention is applied to the PLL circuit of Figure 1 in the form of PI-regulation in processor 3, an implementation in which the cutting off of the rest or remainder is done on the basis of fractions and the integer function, is:

   1) read p;

   2) calculate the integral term, no handling of fractions:

$$C_{int} = C_{int} + K_P \cdot K_I \cdot p \, ,$$

where $K_p$ is the proportional constant and $K_I$ is the integral constant, and $K_P \gg K_I$, e.g. $K_P = 100 \cdot K_I$;

3) accumulate the fractions for the proportional term:

$$\Sigma = + (K_P \cdot p) - int(K_P \cdot p),$$

where int() represents the integer function;

4) When the accumulated sum of fractions for the proportional part reaches one full unit (i.e. the threshold here is one full unit, but can naturally also be e.g. two or three full units), add that unit to the proportional part and save the remains of the fractional part:

```
IF (Σ >= 1)
{
C_Prop = C_Prop + (K_P · p) + int(Σ)
Σ = Σ - int(Σ)
}
ELSE
{
C_Prop = (K_P · p)
}
```

5) Calculate the control value c for the D/A converter: $c = C_{Prop} + C_{Int}$

Although the present invention has been explained on the basis of detailed embodiments, it should be noted that these examples only serve to better explain the invention to a person skilled in the art, and are not intended as a restriction of the invention, the scope of which is defined by the appended claims. Also, reference numerals do not restrict the scope and only serve to make the claims easier to read.

**Claims**

1. In a circuit (1, 2, 3, 4, 5) comprising a digital processing means (3) operating at a first resolution, and a circuit means (4) operating at a second resolution, said second resolution being lower than said first resolution, and receiving an output value ($c_i$) from said processing means (3), a method of adapting the resolution of a digital process value ($d_i$) provided at said first resolution, from said first resolution to said second resolution, for generating said output value ($c_i$), comprising:

- determining (S1) at said second resolution an adapted value ($\{d_i\}_{r2}$) as a function of said digital process value ($d_i$),

- determining (S1) at said first resolution a remainder value ($Rest(\{d_i\}_{r2})$) indicative of the difference between said digital process value ($d_i$) and said adapted value ($\{d_i\}_{r2}$) ,

- adding (S2) said remainder value ($Rest(\{d_i\}_{r2})$) to a summation value ($\Sigma_{rest}$),

- comparing (S3) said summation value ($\Sigma_{rest}$) to a predetermined threshold value (Th), and

- determining (S4, S5) at said second resolution, on the basis of said adapted value ($\{d_i\}_{r2}$), a term ($\delta_i$) to be used in the determination of said output value ($c_i$), where said term ($\delta_i$) is set equal to said adapted value ($\{d_i\}_{r2}$) if said summation value ($\Sigma_{rest}$) is smaller than said predetermined threshold (Th), and said term ($\delta_i$) is set equal to the sum of said adapted value ($\{d_i\}_{r2}$) and one or more resolution intervals ($r_2$) associated with said second resolution, and said summation value ($\Sigma_{rest}$) is reset, if said summation value (rest) is larger than said predetermined threshold (Th).

2. The method according to claim 1, characterized in that said adapted value ($\{d_i\}_{r2}$) is calculated by truncating said digital process value ($d_i$).

3. The method according to claim 1 or 2, characterized in that said remainder value (Rest($\{d_i\}_{r2}$)) is calculated as the difference between said digital process value ($d_i$) and said adapted value ($\{d_i\}_{r2}$).

4. The method according to one of the preceding claims, characterized in that said summation value ($\Sigma_{rest}$) is reset to the difference between the momentary value of said summation value ($\Sigma_{rest}$) and the resolution interval ($r_2$) associated with said second resolution.

5. The method according to one of claims 1 to 3, characterized in that said summation value ($\Sigma_{rest}$) is reset to zero.

6. The method according to one of the preceding claims, characterized in that said circuit (1, 2, 3, 4, 5) is a phase locked loop circuit and said circuit means (4) is a D/A converter for converting the output values ($c_i$) from said processing means (3) into an analogue control signal ($c(t)$) for a voltage controlled oscillator (5).

7. The method according to one of the preceding claims, characterized in that said threshold (Th) is equal to the resolution interval ($r_2$) associated with said second resolution.

8. The method according to one of the preceding claims, characterized in that said output value ($c_i$) is equal to said term ($\delta_i$).

9. The method according to one of claims 1 to 7, characterized in that said output value ($c_i$) is calculated as a sum of said term ($\delta_i$) and further values provided at said second resolution.

10. Method according to claim 9, characterized in that said output value ($c_i$) is a PI-regulation value, where said digital process value ($d_i$) corresponds to the proportional factor of PI-regulation, and the output value ($c_i$) is calculated as the sum of said term ($\delta_i$) and an integral term.

11. A circuit (1, 2, 3, 4, 5) comprising a digital processing means (3) operating at a first resolution, and a circuit means (4) operating at a second resolution, said second resolution being lower than said first resolution, and receiving an output value ($c_i$) from said processing means (3), where in order to adapt the resolution of a digital process value ($d_i$) provided at said first resolution, from said first resolution to said second resolution, for generating said output value ($c_i$), said processing means (3) comprises:

    - a means for determining at said second resolution an adapted value ($\{d_i\}_{r2}$) as a function of said digital process value ($d_i$),

    - a means for determining at said first resolution a remainder value (Rest($\{d_i\}_{r2}$)) indicative of the difference between said digital process value ($d_i$) and said adapted value ($\{d_i\}_{r2}$),

    - a means for adding said remainder value (Rest($\{d_i\}_{r2}$)) to a summation value ($\Sigma_{rest}$),

    - a means for comparing said summation value ($\Sigma_{rest}$) to a predetermined threshold value (Th), and

    - a means for determining at said second resolution, on the basis of said adapted value ($\{d_i\}_{r2}$), a term ($\delta_i$) to be used in the determination of said output value ($c_i$), where said term ($\delta_i$) is set equal to said adapted value ($\{d_i\}_{r2}$) if said summation value ($\Sigma_{rest}$) is smaller than said predetermined threshold (Th), and said term ($\delta_i$) is set equal to the sum of said adapted value ($\{d_i\}_{r2}$) and the resolution interval ($r_2$) associated with said second resolution, and said summation value ($\Sigma_{rest}$) is reset, if said summation value ($\Sigma_{rest}$) is larger than said predetermined threshold (Th).

**12.** The circuit according to claim 1, characterized in that said processing means (3) is arranged such that said adapted value $(\{d_i\}_{r2})$ is calculated by truncating said digital process value $(d_i)$.

**13.** The circuit according to claim 1 or 2, characterized in that said processing means (3) is arranged such that said remainder value $(Rest(\{d_i\}_{r2}))$ is calculated as the difference between said digital process value $(d_i)$ and said adapted value $(\{d_i\}_{r2})$.

**14.** The circuit according to one claims 11 to 13, characterized in that said processing means (3) is arranged such that said summation value $(\Sigma_{rest})$ is reset to the difference between the momentary value of said summation value $(\Sigma_{rest})$ and the resolution interval $(r_2)$ associated with said second resolution.

**15.** The circuit according to one of claims 11 to 13, characterized in that said processing means (3) is arranged such that said summation value $(\Sigma_{rest})$ is reset to zero.

**16.** The circuit according to one of claims 11 to 15, characterized in that said circuit (1, 2, 3, 4, 5) is a phase locked loop circuit and said circuit means (4) is a D/A converter for converting the output values $(c_i)$ from said processing means (3) into an analogue control signal $(c(t))$ for a voltage controlled oscillator (5).

**17.** The circuit according to one of claims 11 to 16, characterized in that said processing means (3) is arranged such that said threshold (Th) is equal to the resolution interval $(r_2)$ associated with said second resolution.

**18.** The circuit according to one of claims 11 to 17, characterized in that said processing means (3) is arranged such that said output value $(c_i)$ is equal to said term $(\delta_i)$.

**19.** The circuit according to one of claims 11 to 17, characterized in that said processing means (3) is arranged such that said output value $(c_i)$ is calculated as a sum of said term $(\delta_i)$ and further values provided at said second resolution.

**20.** The circuit according to claim 19, characterized in that said processing means (3) is arranged such that said output value $(c_i)$ is a PI-regulation value, where said digital process value $(d_i)$ corresponds to the proportional factor of PI-regulation, and the output value $(c_i)$ is calculated as the sum of said term $(\delta_i)$ and an integral term.

EP 1 096 368 A1

## FIG.1

REF → | PHASE COMP | (1) → $p(t)$ → | A/D | (2) → $p_i$ → | PROCESSOR | (3) → $c_i$ → | D/A | (4) → $c(t)$ → | VCO | (5) →

# FIG.2

BEGIN

DETERMINE $\{d_i\}_{r2}$ AND REST $(\{d_i\}_{r2})$ — S1

$\Sigma_{rest} \leftarrow \Sigma_{rest} + REST(\{d_i\}_{r2})$ — S2

S3 — $\Sigma_{rest} > Th$ ?

YES

NO

S8 — NEXT i

S4 — $\delta_i = \{d_i\}_{r2}$

S5 — $\delta_i = \{d_i\}_{r2} + r2/$ RESET $\Sigma_{rest}$

DETERMINE $c_i$ AS FUNCTION OF $\delta_i$ — S6

S7 — END ?

NO

YES

END

9

EP 1 096 368 A1

## EUROPEAN SEARCH REPORT

**European Patent Office**

**Application Number**
EP 99 12 0833

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 314 182 A (NIPPON ELECTRIC CO) 3 May 1989 (1989-05-03) | 1-4,7,8, 11-14, 17,18 | G06F7/48 H03M1/66 |
| | * column 3, line 38 - column 4, line 49; figures 3,4 * | | |
| A | * column 4, line 50 - line 53 * | 6,16 | |
| | --- | | |
| X | US 5 283 577 A (COENEN ANTONIUS J R M) 1 February 1994 (1994-02-01) | 1-4,7,8, 11-14, 17,18 | |
| | * column 4, line 4 - line 34; figure 1 * | | |
| A | * column 1, line 59 - column 2, line 3 * | 6,16 | |
| | ----- | | |

TECHNICAL FIELDS
SEARCHED (Int.Cl.7)

G06F
H03M

The present search report has been drawn up for all claims

| Place of search | Date of completion of the search | Examiner |
|---|---|---|
| THE HAGUE | 14 April 2000 | Beindorff, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

10

**ANNEX TO THE EUROPEAN SEARCH REPORT
ON EUROPEAN PATENT APPLICATION NO.**                EP 99 12 0833

This annex lists the patent family members relating to the patent documents cited in the above—mentioned European search report.
The members are as contained in the European Patent Office EDP file on
The European Patent Office is in no way liable for these particulars which are merely given for the purpose of information.

14-04-2000

| Patent document cited in search report | | Publication date | Patent family member(s) | | Publication date |
|---|---|---|---|---|---|
| EP 0314182 | A | 03-05-1989 | JP | 1117527 A | 10-05-1989 |
| | | | JP | 1977398 C | 17-10-1995 |
| | | | JP | 7003953 B | 18-01-1995 |
| | | | US | 4924223 A | 08-05-1990 |
| US 5283577 | A | 01-02-1994 | NL | 8902368 A | 16-04-1991 |
| | | | NL | 8902751 A | 16-04-1991 |
| | | | AT | 105449 T | 15-05-1994 |
| | | | DE | 69008731 D | 09-06-1994 |
| | | | DE | 69008731 T | 10-11-1994 |
| | | | DK | 493466 T | 06-06-1994 |
| | | | EP | 0493466 A | 08-07-1992 |
| | | | ES | 2053204 T | 16-07-1994 |
| | | | WO | 9104611 A | 04-04-1991 |

EPO FORM P0459

For more details about this annex : see Official Journal of the European Patent Office, No. 12/82